# EUROPÄISCHE PATENTSCHRIFT

(11) **EP 0 815 454 B1**
(45) Veröffentlichungstag und Bekanntmachung des Hinweises auf die Patenterteilung: **27.01.1999**
(21) Anmeldenummer: 95939257.2
(22) Anmeldetag: 10.11.1995
(51) Int. Cl.: G01R 15/06, G01R 1/20

(54) **SPANNUNGSWANDLER**
VOLTAGE TRANSFORMER
TRANSFORMATEUR DE TENSION

(30) Priorität: 13.03.1995 DE 19508582
(43) Veröffentlichungstag der Anmeldung: 07.01.1998
(73) Patentinhaber: Duromer Kunststoffverarbeitungs-GmbH, 01458 Ottendorf-Okrilla (DE)
(72) Erfinder: ERMISCH, Jochen, D-01462 Radebeul (DE); GEORGI, Axel, D-01462 Oberwartha (DE)
(74) Vertreter: Vonnemann, Gerhard, Dr.-Ing.
(86) Internationale Anmeldenummer: EP9504431
(87) Internationale Veröffentlichungsnummer: WO9628736

(56) Entgegenhaltungen:
- EP-A- 0 118 147
- EP-A- 0 134 541
- DE-A- 3 714 945
- FR-A- 2 462 713
- GB-A- 2 168 495
- PATENT ABSTRACTS OF JAPAN vol. 14 no. 396 (E-970) ,27.August 1990 & JP,A,02 148801 (TAIYO YUDEN) 7.Juni 1990,

## Beschreibung

Die Erfindung betrifft einen Spannungswandler mit Spannungsteiler zur Spannungsmessung in Mittel- und Hochspannungsanlagen, mit einer kombinierten Anordnung von Ohmschem Teilerwiderstand und Mitteln zur Kompensation von elektromagnetischen Umgebungseinflüssen, wie z.B. aus EP-A-0 510 427 bereits bekannt ist.

Aus der DE 29 30 672 C2 oder der DE-OS 29 30 767 sind auch derartige Spannungswandler mit Spannungsteiler bekannt. Der bekannte Spannungsteiler besteht aus linsenförmigen Widerstandselementen, die jeweils einen zentralen Durchbruch aufweisen. Die Widerstandselemente sind mit ihren zentralen Durchbrüchen auf einen gemeinsamen Schraubbolzen aufgesteckt, mit dem Sie zusammengehalten und befestigt sind. Auf demselben Schraubbolzen sind auch kapazitiv wirksame Elektroden durch Einklemmen zwischen den linsenförmigen Widerstandselementen befestigt. Die Elektroden halten Störungen durch kapazitive Einflüsse der Umgebung vom Spannungsteiler fern. Die bekannte Anordnung ist aufwendig in der Herstellung, da die einzelnen Widerstandselemente einzeln hergestellt und zusammengebaut werden müssen. Dies gilt um so mehr bei der ebenfalls in den genannten Druckschriften vorgeschlagenen Beschichtung der Widerstandselemente mittels einer Dickfilm-Widerstandspaste. Diese Beschichtung ist für jedes Widerstandselement einzeln vorzunehmen.

Aufgabe der Erfindung ist es, einen gegenüber elektromagnetischen Umgebungseinflüssen unempfindlichen Spannungswandler anzugeben, der einfach aufgebaut und mit geringem Aufwand zu fertigen ist.

Erfindungsgemäß wird diese Aufgabe dadurch gelöst, daß ein Teilerwiderstand einstückig mit einem Meßwiderstand und mit Anzapfungen als auf ein Trägermaterial aufgedampfter Metallwerkstoff oder in Dickschichttechnik ausgeführt ist, wobei die Anzapfungen an den Rändern der Trägerplatte angeordnet sind und mindestens eine Anzapfung mit mindestens einem Kompensationselement verbunden ist. Bei dem Erfindungsgegenstand kann der Spannungsteiler vorteilhaft einfach in einem einzigen Arbeitsgang durch Beschichten eines Trägermaterials hergestellt werden, wobei gleichzeitig der Meßwiderstand und die Anzapfungen für die Kompensationselemente erzeugt werden. Zur Bildung des Spannungswandlers brauchen nur noch die Kompensationselemente mit den genannten Anzapfungen verbunden zu werden.

Ein erfindungsgemäßer Spannungswandler kann wesentlich kleiner und leichter sein und unaufwendiger gefertigt werden. Außerdem lassen sich infolge der geringen Größe und der Fertigungsmethode weitere zusätzliche Bauteile, Schaltungsverbindungen und passive Bauelemente beim Dickschichtprozeß mit integrieren. Bei der Verwendung des Spannungwandlers in Schaltanlagen kann die gesamte Schaltzelle kleiner und kompakter ausgestaltet sein.

Ein weiterer wichtiger Vorteil ist die leistungsarme Ausführung, wodurch ein effektives Zusammenwirken mit modernen Ausführungen der Informationsverarbeitung, zum Beispiel in der Schaltanlagenleittechnik, gewährleistet ist. Außerdem erhält man bei der technisch einheitlichen Ausführung von Ober- und Unterspannungswiderstand des Teilers einen einheitlichen Temperaturausdehnungskoeffizienten und eine einheitliche Temperatur mit dem Vorteil einer sehr geringen Temperaturabhängigkeit des Teilerverhältnisses.

Hinsichtlich einer besonders einfachen Fertigung empfiehlt sich eine bevorzugte Ausführungsform, bei der der Teilerwiderstand auf einer ebenen Trägerplatte und die Anzapfungen an den Rändern der Trägerplatte angeordnet sind. Andere Bauelemente lassen sich an die seitlichen Anzapfungen besonders leicht anschließen.

Um Störungen durch kapazitive Einflüsse der Umgebung von dem Spannungsteiler besonders effektiv fernzuhalten, wird empfohlen, daß als Kompensationselemente Elektroden verwendet werden, die hinsichtlich ihrer Kapazität derart dimensioniert sind, daß sich zufällige und von der Umgebung herrührende kapazitive Einflüsse durch gezielte Elektrodengestaltung weitgehend definieren oder kompensieren lassen. Durch Dimensionierung einer Kapazität am Unterspannungswiderstand in einem bestimmten Verhältnis zur Kapazität am Oberspannungswiderstand wird der kapazitive Einfluß auf das Übertragungsverhalten kompensiert.

Damit wird das Übertragungsverhalten im Frequenzbereich 0...1000 Hz von äußeren Beeinflussungen nur innerhalb vorgegebener Fehlergrenzen beeinträchtigt. Gleichzeitig wird durch die Ausführung der kapazitiv wirksamen Elektroden eine elektrische Feldsteuerung und eine Abschirmung gegenüber EMC-Einflüssen erreicht. Der sich aus dem Aufbau ergebende kapazitive Teiler parallel zum Ohmschen Teiler stellt außerdem einen Schutz gegen Spannungsanhebung am Teilerausgang bei transienten Überspannungen dar.

Die direkte Oberfläche des Dickschichtwiderstandes wird durch die Elektroden außerdem isoliertechnisch entlastet.

In einer bevorzugten Ausführungsform sind die Elektroden in Gießharztechnik ausgeführt, wobei der kapazitiv wirksame Teil aus leitfähigen Kunstharzschichten oder aus Spritzmetallisierung besteht. Dadurch wird eine vollständige Anpassung im Wärmeausdehnungsverhalten erzielt.

Eine weitere bevorzugte Ausführungsform sieht vor, daß die kapazitiven Elektroden aus geeignet geformten Blechteilen bestehen, die über kurze Zuleitungen mit den Anzapfungen des Teilerwiderstands verbunden sind. Insbesondere wenn die kapazitiven Elektroden aus schirmförmigen Metallteilen bestehen, wird neben der kapazitiven Wirkung eine Abschirmwirkung erzielt. Derartige Blechteile können auf einfache Weise und ohne besonderen Aufwand gefertigt und angeschlossen werden.

In einer anderen Ausführungsform werden die kapazitiv wirksamen Elektroden in halbleitfähiger Ausführung, vorzugsweise mit einem Oberflächenwiderstand im Bereich von 10⁸...10¹¹Ω ausgestaltet. Damit kann die Feldsteuerwirkung der Elektroden gezielt beeinflußt werden.

In einer Ausgestaltung der Erfindung, die einen guten Kompromiß zwischen einfachem Aufbau und guter Funktion des Spannungswandlers darstellt, sind drei schirmförmige Elektroden übereinander angeordnet, wobei eine erste Elektrode mit der Hochspannung, eine zweite Elektrode mit einer zweiten Anzapfung des Teilerwiderstandes und eine dritte Elektrode mit einer dritten Anzapfung verbunden ist.

Die Anordnung kann noch verbessert werden durch eine topfförmige, mit dem Erdpotential verbundene vierte Elektrode, die zumindest die dritte Elektrode umschließt. Dabei werden zwischen der dritten und gegebenenfalls zweiten Elektrode und dem Erdpotential weitere Kapazitäten gebildet und der Spannungswandler besser abgeschirmt.

In einer Variante kann die vierte Elektrode auch mit dem Potential des Teilerabgriffes an der vierten Anzapfung verbunden sein, wodurch die Abschirmwirkung bei bestimmten Umgebungseinflüssen noch verbessert werden kann.

Unter besonderen Bedingungen der Umgebungseinflüsse ist eine kapazitive Kompensation nur bis zu einem gewissen Grad möglich. Für diesen Fall wird vorgeschlagen, daß als Kompensationselement mindestens ein weiterer Widerstand parallel zum Teilerwiderstand geschaltet und in dessen Nähe angeordnet ist. Ein solcher Widerstand entwickelt eine gewisse Abschirmwirkung, die gerade aufgrund ihrer halbleitenden Eigenschaften besonders wirksam sein kann.

In einer vorteilhaften Ausführungsform sind der oder die weiteren Widerstände als auf ein Trägermaterial aufgedampfter Metallwerkstoff oder in Dickschichttechnik ausgeführt. Damit kann der weitere Widerstand genauso wie der Spannungsteiler vorteilhaft einfach in einem einzigen Arbeitsgang durch Beschichten eines Trägermaterials hergestellt werden.

Um die Fertigung des Spannungswandlers zu vereinfachen und kostengünstiger zu gestalten, wird empfohlen, daß der oder die weiteren Widerstände in gleicher Bauart wie der Teilerwiderstand auf einer ebenen Trägerplatte mit Anzapfungen an den Rändern der Trägerplatte ausgeführt sind, wobei aber nur der Teilerwiderstand mit dem Meßanschluß verbunden ist. Im Prinzip werden hier mehrere Teilerwiderstände gleicher Bauart verwendet, die vorteilhaft mit denselben Fertigungsanlagen hergestellt werden können. Beim Zusammenbau wird jedoch nur der Teilerwiderstand mit dem Meßanschluß verbunden. Bei den anderen als weitere Widerstände verwendeten Teilern wird die Anzapfung für die Meßspannung nicht mit dem Meßanschluß verbunden.

Eine bevorzugte Ausführungsform sieht vor, daß vier weitere Widerstände kastenförmig um den Teilerwiderstand herum angeordnet sind, so daß ihre Trägerplatten im Schnitt im wesentlichen ein Quadrat bilden, in dem der Teilerwiderstand diagonal angeordnet ist. Aufgrund dieser Anordnung wird der Teilerwiderstand fast vollständig halbleitend abgeschirmt, so daß elektromagnetische Umgebungseinflüsse vom Teilerwiderstand durch die weiteren Widerstände wirkungsvoll abgehalten werden.

Eine einfachere Ausführungsform sieht vor, daß ein weiterer Widerstand direkt neben dem Teilerwiderstand angeordnet ist, so daß die beiden Trägerplatten in einem geringen Abstand im wesentlichen parallel zueinander verlaufen. Diese Ausführungsform benötigt noch weniger Bauteile und ist noch kostengünstiger herstellbar, wobei trotzdem eine ausreichende Kompensationswirkung durch den weiteren Widerstand erzielt wird.

In einer nochmals vereinfachten Ausführungsform ist vorgesehen, daß der Teilerwiderstand und ein weiterer Widerstand auf Vorder- und Rückseite derselben Trägerplatte angeordnet sind. Bei dieser Ausführungsform bringt der Teilerwiderstand sein Kompensationselement schon mit, so daß eine Montage des weiteren Widerstands bzw. ein Zusammenbau kostengünstig eingespart wird.

In einer Weiterbildung der Erfindung ist der erfindungsgemäße Spannungswandler mit Teilerwiderstand und Kompensationsmitteln in das Material eines Isolationsteiles einer Schaltanlage, insbesondere in eine Durchführung oder einen Stützer für Stromschienen eingegossen. Dadurch entsteht ein einstückiges, kompaktes Bauteil, das anstelle der üblichen Isolationsteile, insbesondere durch Führungen oder Stützer für Stromschienen verwendet werden kann. In diesem Fall entfällt die Notwendigkeit, einen Spannungswandler mit einem Gehäuse zu versehen, und in der Schaltanlage ergeben sich erhebliche Einsparungen an Gewicht und Volumen. Dabei hat diese Ausführungsform den zusätzlichen Vorteil, daß herkömmliche Isolationsteile der Schaltanlage auch im Rahmen einer Umrüstung durch erfindungsgemäße Isolationsteile mit Spannungswandler auf einfachste Weise ersetzt werden können.

Dies gilt insbesondere für Stützer für Stromschienen gemäß einem der Ansprüche 19 oder 20, in deren Material ein erfindungsgemäßer Spannungswandler eingegossen ist.

In einer Weiterbildung des eingegossenen Spannungswandlers ist vorgesehen, daß die Widerstände und insbesondere der Teilerwiderstand mit Silikonkautschuk überzogen sind. Diese Maßnahme stellt sicher, daß die Widerstände, insbesondere in Dickschichttechnik auf einer ebenen Trägerplatte ausgeführte Widerstände, einen gewissen Spielraum erhalten, innerhalb dessen geringfügige Verschiebungen aufgrund von thermischer Belastung der Widerstände möglich sind, ohne daß eine Zerstörung der Widerstände oder des Isolationsteiles befürchtet werden muß. Bei einem Gesamtwiderstand von typischerweise von 50 MΩ und einer Spannung von 12 kV tritt am Teilerwiderstand eine Verlustleistung von ungefähr 3 W auf, die zu einer merklichen Erwärmung des Widerstands von etwa 6°C führt.

Weitere Vorteile und Einzelheiten der Erfindung ergeben sich aus der nachfolgenden Beschreibung von Ausführungsbeispielen anhand der Zeichnungen.

Die Figuren zeigen im einzelnen:
- Figur 1:: eine erste schematische Ausführungsform des erfindungsgemäßen Spannungswandlers mit zugehörigem Ersatzschaltbild,
- Figur 2:: eine zweite schematische Ausführungsform des erfindungsgemäßen Spannungswandlers mit zugehörigem Ersatzschaltbild,
- Figur 3:: eine Prinzipskizze in perspektivischer Darstellung einer dritten Ausführungsform, eines erfindungsgemäßen Spannungswandlers,
- Figur 4:: eine teilweise geschnittene Darstellung eines Ausführungsbeispiels der dritten Ausführungsform,
- Figur 5:: einen Schnitt gemäß Linie A-A von Figur 4,
- Figur 6:: eine teilweise geschnittene Darstellung eines weiteren Ausführungsbeispiels der dritten Ausführungsform,
- Figur 7:: einen Schnitt gemäß Linie B-B von Figur 6,
- Figur 8:: eine Draufsicht auf ein weiteres Ausführungsbeispiel der dritten Ausführungsform.

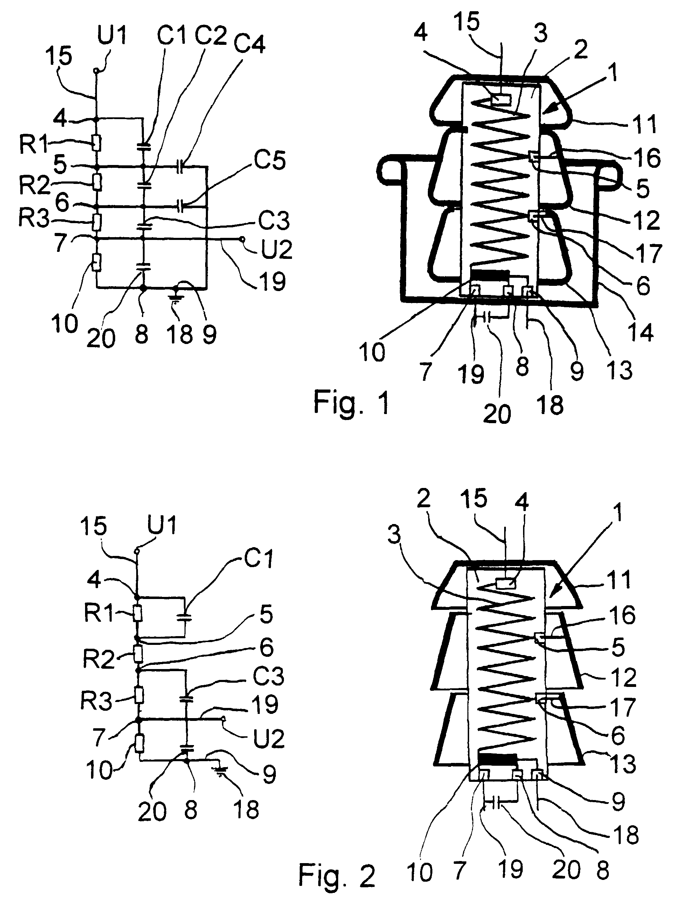

Der in Figur 1 dargestellte Spannungswandler besitzt einen Spannungsteiler 1, der eine Trägerplatte 2 und einen auf der Trägerplatte 2 mittels Dickschichttechnik aufgebrachte Teilerwiderstand 3 aufweist. Der Teilerwiderstand 3 ist mit Anzapfungen 4, 5, 6, 7, 8, 9 versehen, und weist einen Abschnitt auf, der als Meßwiderstand 10 ausgeführt ist. Um den Spannungsteiler 1 herum sind drei schirmförmige Elektroden 11, 12, 13 angeordnet, die untereinander bzw. gegenüber dem Erdpotential kapazitiv wirksam sind. Eine erste Elektrode 11 ist mit der Hochspannungsleitung 15 verbunden, die ihrerseits an einer ersten Anzapfung 4 des Teilerwiderstands 3 angeschlossen ist. Eine zweite Elektrode 12 ist mit einer zweiten Anzapfung 5 des Teilerwiderstands 3 über eine kurze Zuleitung 16 verbunden. Eine dritte Elektrode 13 ist über eine weitere kurze Zuleitung 17 mit einer dritten Anzapfung 6 des Teilerwiderstands 3 verbunden. Die drei Elektroden 11, 12, 13 sind übereinander gestapelt angeordnet.

Sämtliche Anzapfungen 4 bis 9 sind an den Rändern der Trägerplatte 2 des Teilerwiderstands 3 angeordnet, um eine einfache Verbindung mit der Hochspannungsleitung 15, den kurzen Zuleitungen 16, 17 der Erdleitung 18 und der Meßleitung 19 zu ermöglichen.

Die Elektroden sind weiterhin in ihren Dimensionen auf die gewünschte Kapazität abgestimmt, so daß kapazitive Einflüsse der Umgebung weitgehend neutralisiert werden.

Zwar sind die Elektroden 11, 12, 13 in den gezeigten Beispielen als schirmförmige Blechteile ausgeführt, sie können jedoch auch in Gießharztechnik ausgeführt sein, wobei der kapazitiv wirksame Teil aus einer leitfähigen Kunstharzschicht oder aus einer Spritzmetallisierung bestehen kann.

Bei dem Ersatzschaltbild von Figur 1 wird eine Hochspannung U1 an die erste Anzapfung 4 des Teilerwiderstands 3 angelegt. Zwischen der ersten Anzapfung 4 und der zweiten Anzapfung 5 wird ein erster Teilwiderstand R1 gebildet. Zwischen der zweiten Anzapfung 5 und der dritten Anzapfung 6 wird ein zweiter Teilwiderstand R2 gebildet. Zwischen der dritten Anzapfung 6 und der vierten Anzapfung 7 wird ein dritter Teilwiderstand R3 gebildet. Zwischen der vierten Anzapfung 7 und der fünften Anzapfung 8 wird der Meßwiderstand 10 gebildet. Schließlich ist die Erdleitung 18 mit der sechsten Anzapfung 9 verbunden. Die drei Elektroden 11, 12, 13 bilden untereinander die Kapazitäten C1, C2, C3. Parallel zum Meßwiderstand 10 ist außerhalb der Trägerplatte 2 ein Kompensationskondensator 20 an die vierte Anzapfung 7 und die fünfte Anzapfung 8 angeschlossen. Die Meßspannung U2 wird über die Meßleitung 19 abgenommen.

Bei dem Ausführungsbeispiel gemäß Figur 1 ist eine vierte topfförmige Elektrode 14 angeordnet, die mit dem Erdpotential verbunden ist und die dritte Elektrode 13 ganz sowie die zweite Elektrode 12 teilweise umschließt. Diese vierte Elektrode 14 schirmt den Spannungsteiler 1 teilweise ab und bildet weitere Kapazitäten C4 und C5 gegenüber der zweiten Elektrode 12 und der dritten Elektrode 13.

Bei dem Ausführungsbeispiel gemäß Figur 2 fehlt die vierte Elektrode und die drei anderen Elektroden 11, 12, 13 sind in ihrer Form und Anordnung etwas modifiziert, so daß sich in dem zugehörigen Ersatzschaltbild nur die Kapazitäten C1 und C3 ergeben.

Der beschriebene Spannungswandler ist für Spannungen von etwa 12 kV (Mittelspannung) geeignet und besitzt ein Teilerverhältnis von 1:10000, so daß die Meßspannung im Bereich von 1 V liegt.

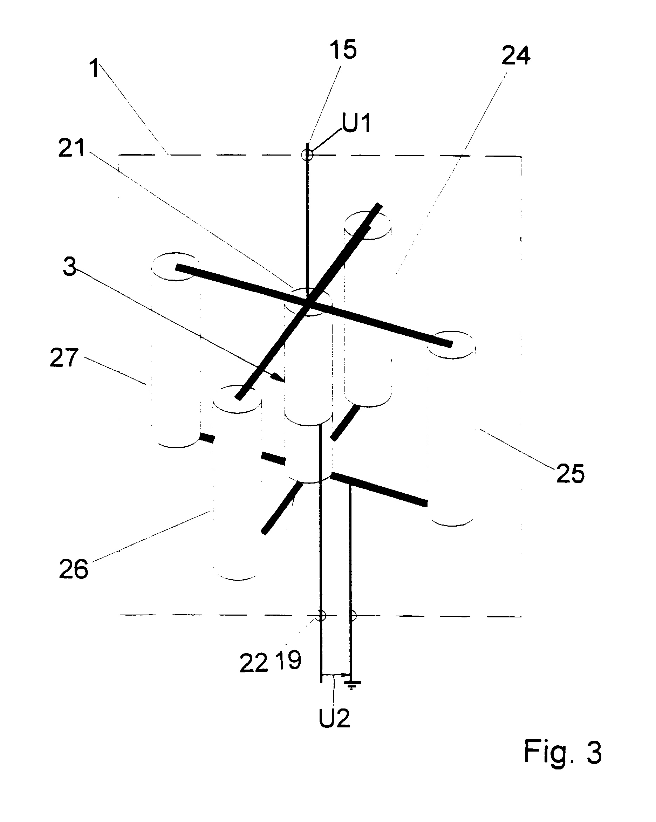

In Figur 3 erkennt man wieder den Spannungsteiler 1, der hier aus einem Oberspannungswiderstand 21 und einem Unterspannungswiderstand 22 besteht, zwischen denen eine Anzapfung 23 angeordnet ist. An der Anzapfung 23 ist die Meßleitung 19 angeschlossen, an der die Meßspannung U2 anliegt. Die Hochspannung U1 wird über die Hochspannungsleitung 15 zugeführt.

Um den Teilerwiderstand 3 herum sind vier weitere Widerstände 24, 25, 26, 27 angeordnet, die parallel zum Teilerwiderstand 3 geschaltet und im übrigen auch parallel zu diesem angeordnet sind. Dadurch entwickeln die weiteren Widerstände 24 bis 27 eine gewisse halbleitende Abschirmwirkung zur Kompensation von elektromagnetischen Umgebungseinflüssen.

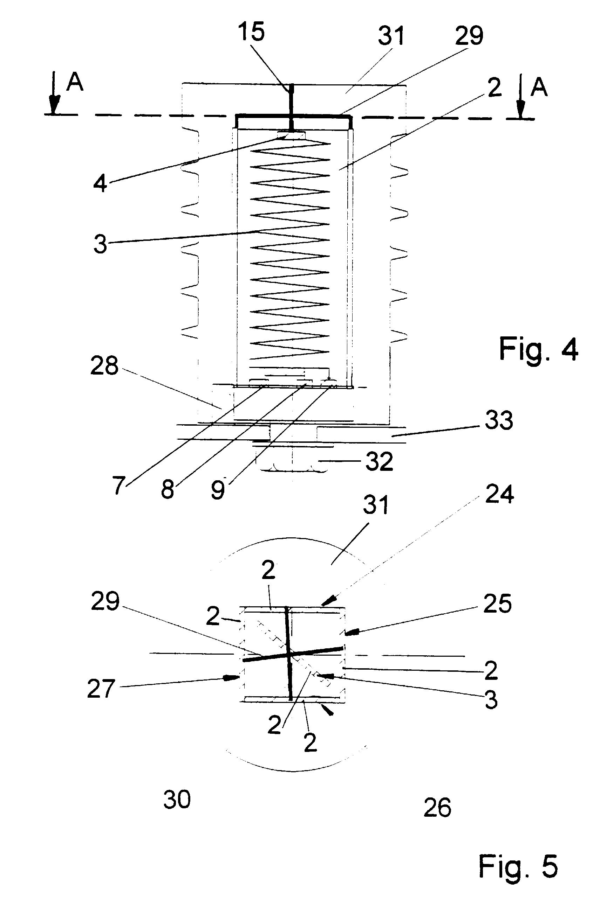

Bei dem in den Figuren 4 und 5 dargestellten Ausführungsbeispiel sind die vier weiteren Widerstände 24 bis 27 genauso wie der Teilerwiderstand 3 jeweils auf einer ebenen Trägerplatte 2 mit Anzapfungen 4, 7, 8, 9 an den Rändern der Trägerplatte 2 in Dickschichttechnik ausgeführt, wobei aber nur die Anzapfung 7 des Teilerwiderstands 3 mit dem Meßanschluß 28 verbunden ist. Die Hochspannungsleitung 15 ist an die erste Anzapfung 4 des Teilerwiderstands 3 und über zwei Verbinder 29, 30 an entsprechende Anschlüsse der weiteren Widerstände 24 bis 27 angeschlossen. Wie man am besten in Figur 5 erkennt, sind die vier weiteren Widerstände 24 bis 27 kastenförmig um den Teilerwiderstand 3 herum angeordnet, so daß ihre Trägerplatten 2 im Schnitt ein Quadrat bilden, in dem der Teilerwiderstand 3 diagonal angeordnet ist. Weiterhin ist die gesamte Spannungswandleranordnung in das Material eines Stützers 31 für Stromschienen eingegossen. Solche Stützer 31 werden in Schaltanlagen als Isolationsteil und zur Befestigung und Abstützung von Stromschienen verwendet, wobei die Stützer 31 mittels einer Befestigungsschraube 32 an einer Brückenplatte 33 befestigt sind. Die Befestigungsschraube 32 stellt gleichzeitig eine Erdverbindung zu der Anzapfung 9 des Teilerwiderstands 3 her. Auf der Oberseite des Stützers 31 wird eine nicht gezeigte Stromschiene mittels einer nicht gezeigten Befestigungsschraube befestigt, wobei gleichzeitig ein Kontakt zur Hochspannungsleitung 15 hergestellt wird.

Vor dem Eingießen in das Material des Stützers 31 werden der Teilerwiderstand 3 und die weiteren Widerstände 24 bis 27 mit Silikonkautschuk überzogen, um eine geringe Bewegungsfreiheit der Widerstände 24 bis 27 und des Teilerwiderstands 3 gegenüber dem Material des Stützers 31 unter thermischer Belastung zu gewährleisten.

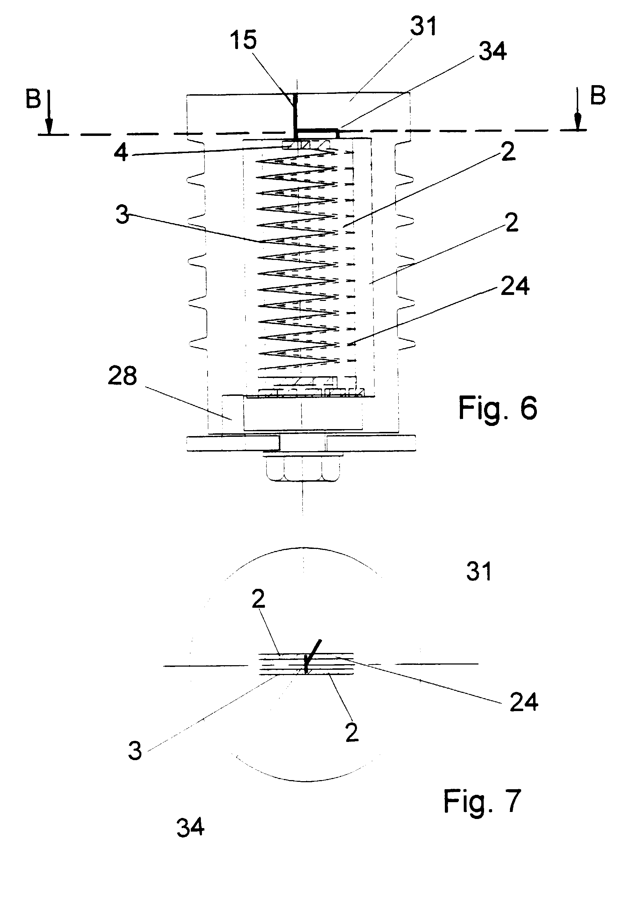

In die Figuren 6 und 7 ist wiederum ein Stützer 31 mit eingegossenem Spannungswandler dargestellt, der aber bei diesem Ausführungsbeispiel aus dem Teilerwiderstand 3 und nur einem weiteren Widerstand 24 gebildet wird, wobei die beiden Trägerplatten 2 in einem geringen Abstand von etwa der Dicke einer Trägerplatte im wesentlichen parallel zueinander verlaufen. Die Hochspannungsleitung 15 ist über einen Verbinder 34 sowohl mit der ersten Anzapfung 4 des Teilerwiderstands 3 als auch mit der entsprechenden Anzapfung des weiteren Widerstands 24 verbunden.

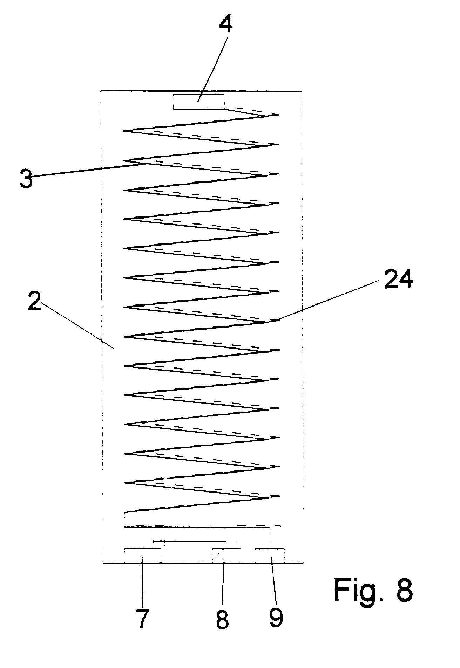

Bei dem im Figur 8 dargestellten Spannungswandler ist auf der Vorderseite der Trägerplatte 2 der Teilerwiderstand 3 und auf der Rückseite derselben Trägerplatte 2 ein weiterer Widerstand 24 angeordnet. Dabei ist der weitere Widerstand 24 mit der ersten Anzapfung 4 des Teilerwiderstands 3 verbunden, an die die Hochspannung angelegt wird. Auch die mit der Erdleitung verbundene Anzapfung des Teilerwiderstands 3 ist in Kontakt mit dem anderen Ende des weiteren Widerstands 24. Die vierte Anzapfung 7 und die fünfte Anzapfung 8, die zum Abgriff der Meßspannung dienen, sind jedoch nur mit dem Teilerwiderstand 3 verbunden.

### Bezugszeichenliste

- 1: Spannungsteiler
- 2: Trägerplatte
- 3: Teilerwiderstand
- 4: erste Anzapfung
- 5: zweite Anzapfung
- 6: dritte Anzapfung
- 7: vierte Anzapfung
- 8: fünfte Anzapfung
- 9: sechste Anzapfung
- 10: Meßwiderstand
- 11: erste Elektrode
- 12: zweite Elektrode
- 13: dritte Elektrode
- 14: vierte Elektrode
- 15: Hochspannunsleitung
- 16: Zuleitung
- 17: Zuleitung
- 18: Erdleitung
- 19: Meßleitung
- 20: Kompensationskondensator
- 21: Oberspannungswiderstand
- 22: Unterspannungswiderstand
- 23: Anzapfung
- 24: weiterer Widerstand
- 25: weiterer Widerstand
- 26: weiterer Widerstand
- 27: weiterer Widerstand
- 28: Meßanschluß
- 29: Verbinder
- 30: Verbinder
- 31: Stützer
- 32: Befestigungsschraube
- 33: Brückenplatte
- 34: Verbinder
- U1: Hochspannung
- U2: Meßspannung
- R1: erster Teilwiderstand
- R2: zweiter Teilwiderstand
- R3: dritter Teilwiderstand
- C1: Kapazität
- C2: Kapazität
- C3: Kapazität
- C4: Kapazität
- C5: Kapazität

## Patentansprüche

1. Spannungswandler mit Spannungsteiler (1) zur Spannungsmessung in Mittel- und Hochspannungsanlagen, mit einer kombinierten Anordnung von Ohmschem Teilerwiderstand (3) und Mitteln (11 bis 14, 24 bis 27) zur Kompensation von elektromagnetischen Umgebungseinflüssen, **dadurch gekennzeichnet,** daß ein Teilerwiderstand (3) einstückig mit einem Meßwiderstand (10) und mit Anzapfungen (4 bis 9) als auf eine Trägerplatte (2) aufgedampfter Metallwerkstoff oder in Dickschichttechnik ausgeführt ist, wobei die Anzapfungen (4 bis 9) an den Rändern der Trägerplatte (2) angeordnet sind und mindestens eine Anzapfung (4 bis 9) mit mindestens einem Kompensationselement (11 bis 14, 24 bis 27) verbunden ist.

2. Spannungswandler nach Anspruch 1, **dadurch gekennzeichnet**, daß als Kompensationselemente Elektroden (11, 12, 13) verwendet werden, die derart dimensioniert sind, daß zufällige und von der Umgebung herrührende kapazitive Einflüsse weitgehend kompensiert werden, insbesondere dadurch, daß die Kapazität am Unterspannungswiderstand (22) in einem bestimmten Verhältnis zur Kapazität am Oberspannungswiderstand (21) steht.

3. Spannungswandler nach Anspruch 2, **dadurch gekennzeichnet**, daß die Elektroden in Gießharztechnik ausgeführt sind, wobei der kapazitiv wirksame Teil aus leitfähigen Kunstharzschichten oder Spritzmetallisierung besteht.

4. Spannungswandler nach Anspruch 2, **dadurch gekennzeichnet**, daß die kapazitiven Elektroden (11, 12, 13) aus geeignet geformten Blechteilen bestehen, die über kurze Zuleitungen (16, 17) mit den Anzapfungen (4, 5, 6) des Teilerwiderstands (3) verbunden sind.

5. Spannungswandler nach Anspruch 2, **dadurch gekennzeichnet**, daß die kapazitiven Elektroden (11, 12, 13) aus schirmförmigen Metallteilen bestehen.

6. Spannungswandler nach Anspruch 2, **dadurch gekennzeichnet**, daß die Elektroden halbleitfähig ausgestaltet sind, vorzugsweise mit einem Oberflächenwiderstand im Bereich von 10⁸...10¹¹ Ω.

7. Spannungswandler nach Anspruch 4, 5 oder 6, **dadurch gekennzeichnet,** daß drei schirmförmige Elektroden (11, 12, 13) übereinander angeordnet sind, wobei eine erste Elektrode (11) mit der Hochspannung (U1), eine zweite Elektrode (12) mit einer zweiten Anzapfung (5) des Teilerwiderstands (3) und eine dritte Elektrode (13) mit einer dritten Anzapfung (6) verbunden ist.

8. Spannungswandler nach Anspruch 7, **dadurch gekennzeichnet**, daß eine topfförmige, mit dem Erdpotential verbundene vierte Elektrode (14) vorgesehen ist, die zumindest die dritte Elektrode (13) umschließt.

9. Spannungswandler nach Anspruch 7, **dadurch gekennzeichnet**, daß eine topfförmige, mit dem Potential des Teilerabgriffes an der vierten Anzapfung (7) verbundene vierte Elektrode (14) vorgesehen ist, die zumindest einen Teil des Teilerwiderstandes umschließt.

10. Spannungswandler nach Anspruch 1, **dadurch gekennzeichnet**, daß als Kompensationselement mindestens ein weiterer Widerstand (24, 25, 26, 27) parallel zum Teilerwiderstand (3) geschaltet und in dessen Nähe angeordnet ist.

11. Spannungswandler nach Anspruch 10, **dadurch gekennzeichnet**, daß der oder die weiteren Widerstände (24, 25, 26, 27) als auf ein Trägermaterial (2) aufgedampfter Metallwerkstoff oder in Dickschichttechnik ausgeführt ist sind.

12. Spannungswandler nach Anspruch 10 oder 11, **dadurch gekennzeichnet,** daß der oder die weiteren Widerstände (24, 25, 26, 27) in gleicher Bauart wie der Teilerwiderstand (3) auf einer ebenen Trägerplatte (2) mit Anzapfungen (4, 7, 8, 9) an den Rändern der Trägerplatte (2) ausgeführt ist sind, wobei aber nur der Teilerwiderstand (3) mit dem Meßanschluß (28) verbunden ist.

13. Spannungswandler nach Anspruch 12, **dadurch gekennzeichet**, daß vier weitere Widerstände (24, 25, 26, 27) kastenförmig um den Teilerwiderstand (3) herum angeordnet sind, so daß ihre Trägerplatten (2) im Schnitt im wesentlichen ein Quadrat bilden, in dem der Teilerwiderstand (3) diagonal angeordnet ist.

14. Spannungswandler nach Anspruch 12, **dadurch gekennzeichnet**, daß ein weiterer Widerstand (24) direkt neben dem Teilerwiderstand (3) angeordnet ist, so daß die beiden Trägerplatten (2) in einem geringen Abstand im wesentlichen parallel zueinander verlaufen.

15. Spannungswandler nach Anspruch 12, **dadurch gekennzeichnet**, daß der Teilerwiderstand (3) und ein weiterer Widerstand (24) auf Vorder- und Rückseite derselben Trägerplatte (2) angeordnet sind.

16. Spannungswandler nach einem der Ansprüche 1 bis 15, **dadurch gekennzeichnet**, daß der Spannungswandler in das Material eines Isolationsteiles einer Schaltanlage, insbesondere in eine Durchführung oder einen Stützer (31) für Stromschienen eingegossen ist.

17. Spannungswandler nach Anspruch 16, **dadurch gekennzeichnet**, daß die Widerstände (24, 25, 26, 27) des Spannungswandlers und insbesondere der Teilerwiderstand (3) mit Silikonkautschuk überzogen sind.

18. Stützer für Stromschienen, Insbesondere von Schaltanlagen, **dadurch gekennzeichnet**, daß in das Material des Stützers (31) ein Spannungswandler gemäß einem der Ansprüche 1 bis 15 eingegossen ist.

19. Stützer nach Anspruch 18, **dadurch gekennzeichnet**, daß die Widerstände (24, 25, 26, 27) des Spannungswandlers und insbesondere der Teilerwiderstand (3) mit Silikonkautschuk überzogen sind.

## Claims

1. Voltage transformer with voltage divider (1) for voltage measurement in medium-voltage and high-voltage installations, with a combined arrangement of ohmic scaling resistor (3) and means (11 to 14, 24 to 27) for compensating electromagnetic environmental influences, characterised in that a scaling resistor (3) is constructed in one piece with a measuring resistor (10) and with taps (4 to 9) as metallic material which is vapour-deposited onto a carrier plate (2) or by means of thick-film technology, the taps (4 to 9) being arranged at the edges of the carrier plate (2) and at least one tap (4 to 9) being connected to at least one compensating element (11 to 14, 24 to 27).

2. Voltage transformer according to Claim 1, characterised in that by way of compensating elements use is made of electrodes (11, 12, 13) which are so dimensioned that random capacitive influences stemming from the environment are largely compensated, in particular by the capacitance at the low-tension resistor (22) being in a certain proportion to the capacitance at the high-tension resistor (21).

3. Voltage transformer according to claim 2, characterised in that the electrodes are constructed by means of casting-resin technology, the capacitively active part consisting of conductive layers of synthetic resin or spray metallisation.

4. Voltage transformer according to Claim 2, characterised in that the capacitive electrodes (11, 12, 13) consist of suitably shaped sheet-metal parts which are connected via short connecting leads (16, 17) to the taps (4, 5, 6) of the scaling resistor (3).

5. Voltage transformer according to Claim 2, characterised in that the capacitive electrodes (11, 12, 13) consist of Umbrella-shaped metallic parts.

6. Voltage transformer according to Claim 2, characterised in that the electrodes are contigured to be semiconductive, preferably with a surface resistance in the range from 10⁸ to 10¹¹ Ω.

7. Voltage transformer according to Claim 4, 5 or 6, characterised in that three umbrella-shaped electrodes (11, 12, 13) are arranged above one another, a first electrode (11) being connected to the high voltage (U1), a second electrode being connected to a second tap (5) of the scaling resistor (3) and a third electrode (13) being connected to a third tap (6).

8. Voltage transformer according to Claim 7, characterised in that a pot-shaped fourth electrode (14) connected to earth potential is provided which surrounds at least the third electrode (13).

9. Voltage transformer according to Claim 7, characterised in that a pot-shaped fourth electrode (14) connected to the potential of the divider pick-up at the fourth tap (7) is provided which surrounds at least a part of the scaling resistor.

10. Voltage transformer according to Claim 1, characterised in that by way of compensating element at least one additional resistor (24, 25, 26, 27) is connected parallel to the scaling resistor (3) and arranged in the vicinity thereof.

11. Voltage transformer according to Claim 10, characterised in that the additional resistor(s) (24, 25, 26, 27) is/are constructed as metallic material which is vapour-deposited onto a carrier material (2) or by means of thick-film technology.

12. Voltage transformer according to Claim 10 or 11, characterised in that the additional resistor(s) (24, 25, 26, 27) is/are constructed in the same style as the partial resistor (3) on a flat carrier plate (2) with taps (4, 7, 8, 9) at the edges of the carrier plate (2), but with only the scaling resistor (3) connected to the measuring port (28).

13. Voltage transformer according to Claim 12, characterised in that four additional resistor(s) (24, 25, 26, 27) are arranged in box-like manner around the scaling resistor (3), so that in section their carrier plates (2) substantially form a square in which the scaling resistor (3) is arranged diagonally.

14. Voltage transformer according to Claim 12, characterised in that an additional resistor (24) is arranged directly alongside the scaling resistor (3), so that the two carrier plates (2) are substantially parallel to one another with a small spacing.

15. Voltage transformer according to Claim 12, characterised in that the scaling resistor (3) and an additional resistor (24) are arranged on the front and rear sides of the same carrier plate (2).

16. Voltage transformer according to one of Claims 1 to 15, characterised in that the voltage transformer is cast into the material of an insulating part of a switching installation, in particular into a bushing or an insulated support (31) for bus bars.

17. voltage transformer according to Claim 16, characterised in that the resistors (24, 25, 26, 27) of the voltage transformer and in particular the scaling resistor (3) are coated with silicone rubber.

18. Insulated support for bus bars, in particular pertaining to switching installations, characterised in that a voltage transformer according to one of Claims 1 to 15 is cast into the material of the insulated support (31).

19. Insulated support according to Claim 18, characterised in that the resistors (24, 25, 26, 27) of the voltage transformer and in particular the scaling resistor (3) are coated with silicone rubber.

## Revendications

1. Transformateur de tension comprenant un diviseur de tension (1) pour mesurer la tension dans des installations de moyennes et hautes tensions, comprenant un dispositif combiné d'une résistance diviseur ohmique (3) et de moyens (11-14, 24-27) pour compenser des influences électromagnétiques de l'environnement,
caractérisé en ce qu'
une résistance partielle (3) est réalisée en une seule pièce avec une résistance de mesure (10) et des bornes (4-9) comme métal vaporisé sur une plaque de support (2) ou en technique des couches épaisses, et les bornes (4-9) sont prévues au niveau des bords de la plaque de support (2) et au moins une borne (4-9) est reliée à au moins un élément de compensation (11-14, 24-27).

2. Transformateur de tension selon la revendication 1,
caractérisé en ce que
les éléments de compensation sont des électrodes (11, 12, 13) dimensionnées de façon à compenser dans une très large mesure des influences capacitives aléatoires ou provenant de l'environnement, notamment en ce que la capacité de la résistance de sous tension (22) se trouve dans un rapport déterminé avec la capacité de la résistance de surtension (21).

3. Transformateur de tension selon la revendication 2,
caractérisé en ce que
les électrodes sont réalisées en technique de résine moulée, la partie capacitive étant formée par des couches de résine synthétique conductrices ou par métallisations par pulvérisation.

4. Transformateur de tension selon la revendication 2,
caractérisé en ce que
les électrodes capacitives (11, 12, 13) sont des pièces en tôle de forme appropriée, reliées par de courtes lignes de liaison (16, 17) aux bornes (4, 5, 6) de la résistance diviseur de tension (3).

5. Transformateur de tension selon la revendication 2,
caractérisé en ce que
les électrodes capacitives (11, 12, 13) sont des pièces métalliques en forme d'écrans.

6. Transformateur de tension selon la revendication 2,
caractérisé en ce que
les électrodes sont semi-conductrices, de préférence avec une résistance de surface de l'ordre de 10⁸ ...10¹¹ Ω.

7. Transformateur de tension selon l'une des revendications 4, 5, 6,
caractérisé par
trois électrodes (11, 12, 13) en forme d'écrans, superposées, une première électrode (11) étant reliée à la haute tension (U1), une seconde électrode (12) étant reliée à une seconde borne (5) de la résistance de diviseur (3) et une troisième électrode (13) étant reliée à une troisième borne (6).

8. Transformateur de tension selon la revendication 7,
caractérisé par
une quatrième électrode (14) en forme de pot, reliée à la masse, entoure au moins la troisième électrode (13).

9. Transformateur de tension selon la revendication 7,
caractérisé par
une quatrième électrode (14) en forme de pot, reliée au potentiel de la borne de diviseur sur la quatrième borne (7), et cette quatrième électrode (14) entoure au moins en partie la résistance diviseur.

10. Transformateur de tension selon la revendication 1,
caractérisé en ce que
l'élément de compensation est constitué par au moins une autre résistance (24, 25, 26, 27) branchée en parallèle sur la résistance diviseur (3) et au voisinage de celle-ci.

11. Transformateur de tension selon la revendication 10,
caractérisé en ce que
la ou les autres résistances (24, 25, 26, 27) sont réalisées comme métal vaporisé sur un support (2) ou encore en technique des couches épaisses.

12. Transformateur de tension selon la revendication 10 ou 11,
caractérisé en ce que
la ou les autres résistances (24, 25, 26, 27) sont réalisées, suivant la même construction que la résistance diviseur (3), sur une plaque de support (2), plane avec des bornes (4, 7, 8, 9) au bord de la plaque de support (2), mais seulement la résistance diviseur (3) est reliée à la borne de mesure (28).

13. Diviseur de tension selon la revendication 12,
caractérisé en ce que
quatre autres résistances (24, 25, 26, 27) sont disposées en forme de caissons autour de la résistance diviseur (3) pour que leur plaque de support (2) forme en coupe essentiellement un carré dans lequel la résistance diviseur (3) forme une diagonale.

14. Diviseur de tension selon la revendication 12,
caractérisé par
une autre résistance (24) prévue directement à côté de la résistance diviseur (3) pour que les deux plaques dE support (2) passent à faible distance essentiellement parallèlement les unes par rapport aux autres.

15. Diviseur de tension selon la revendication 12,
caractérisé en ce que
la résistance de diviseur (3) et une autre résistance (24) sont prévues sur le côté avant et le côté arrière de la même plaque de support (2).

16. Diviseur de tension selon l'une quelconque des revendications 1 à 15,
caractérisé en ce que
le transformateur de tension est noyé dans la matière d'une pièce d'isolation d'une installation de commutation, notamment dans un passage ou un appui (31) pour des rails de courant.

17. Diviseur de tension selon la revendication 16,
caractérisé en ce que
les résistances (24, 25, 26, 27) du transformateur de tension et notamment la résistance de diviseur (3) sont revêtues de caoutchouc silicone.

18. Appui pour rail électrique, notamment installation de commutation,
caractérisé en ce que
dans la matière de l'appui (31) on a noyé un transformateur de tension selon l'une des revendications 1 à 15.

19. Appui selon la revendication 18,
caractérisé en ce que
les résistances (24, 25, 26, 27) du transformateur de tension et notamment la résistance de diviseur (3) sont revêtues de caoutchouc siliconé.
